# EUROPEAN PATENT SPECIFICATION

(11) **EP 3 532 216 B1**
(45) Date of publication and mention of the grant of the patent: **30.03.2022**
(21) Application number: 17794192.9
(22) Date of filing: 23.10.2017
(51) Int. Cl.: B22C 9/02, B22C 9/10, B22C 13/08, B22D 29/00, B28B 1/00, B29C 64/124, B29C 64/135, B29C 64/129, G03F 7/00, G03F 7/20, B22C 9/04, B22C 9/22, B33Y 10/00, B33Y 80/00

(54) **A METHOD FOR FABRICATING AN INTEGRATED CERAMIC CORE-SHELL CASTING MOLD FOR A TURBINE BLADE OR VANE HAVING THIN ROOT COMPONENTS**
VERFAHREN ZUR HERSTELLUNG EINER INTEGRIERTEN KERAMIK-KERN-SCHALEN-GUSSFORM FÜR EINE TURBINENSCHAUFEL ODER LEITSCHAUFEL MIT DÜNNEN WURZELKOMPONENTEN
PROCÉDÉ DE FABRICATION D'UN MOULE DE COULÉE À NOYAU-COQUE CÉRAMIQUE INTÉGRÉ POUR UNE AUBE OU UNE PALE DE TURBINE AVEC DES COMPOSANTS À RACINE FINE

(30) Priority: 13.12.2016 US 201615377766
(43) Date of publication of application: 04.09.2019
(73) Proprietor: General Electric Company, Schenectady, NY 12345 (US)
(72) Inventor: GARAY, Gregory, Terrence, Cincinnati, OH 45215 (US); YANG, Xi, Alpha, OH 45301 (US); DEINES, James, Herbert, Cincinnati, OH 45215 (US)
(74) Representative: Hafner & Kohl PartmbB
(86) International application number: PCT/US2017/057874
(87) International publication number: WO 2018/111405

(56) References cited:
- US-A- 6 117 612
- US-A1- 2008 006 384
- US-A1- 2010 003 619
- US-A1- 2010 028 645
- US-A1- 2016 221 262
- US-A1- 2016 325 493
- US-B2- 8 851 151

## Description

### INTRODUCTION

The present disclosure generally relates to investment casting core-shell mold components and processes utilizing these components. The core-shell mold made in accordance with the present invention includes integrated ceramic indentations between the core and shell of the mold which is utilized to form thin root components, i.e.,
angel wings, damper lugs and skirts in the turbine blade or stator vane made from these molds. The integrated core-shell molds provide useful properties in casting operations, such as in the casting of superalloys used to make turbine blades and vanes for jet aircraft engines or power generation turbine components.

### BACKGROUND

Many modern engines and next generation turbine engines require components and parts having intricate and complex geometries, which require new types of materials and manufacturing techniques. Conventional techniques for manufacturing engine parts and components involve the laborious process of investment or lost-wax casting. One example of investment casting involves the manufacture of a typical rotor blade used in a gas turbine engine. A turbine blade typically includes hollow airfoils that have radial channels extending along the span of a blade having at least one or more inlets for receiving pressurized cooling air during operation in the engine. The various cooling passages in a blade typically include a serpentine channel disposed in the middle of the airfoil between the leading and trailing edges. The airfoil typically includes inlets extending through the blade for receiving pressurized cooling air, which include local features such as short turbulator ribs or pins for increasing the heat transfer between the heated sidewalls of the airfoil and the internal cooling air.

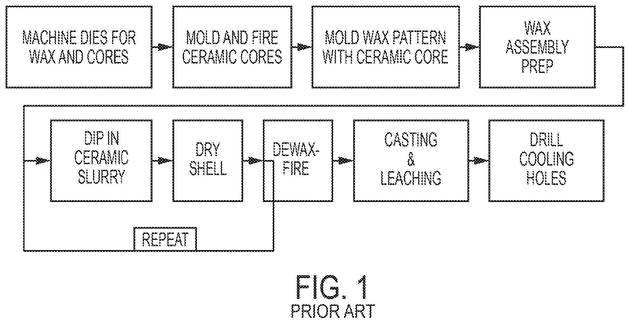

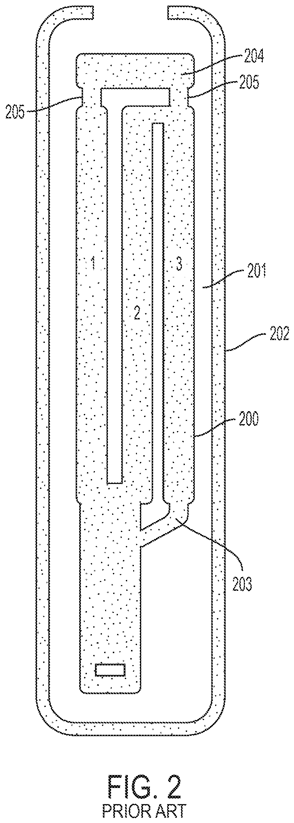

The manufacture of these turbine blades, typically from high strength, superalloy metal materials, involves numerous steps shown in FIG. 1. First, a precision ceramic core is manufactured to conform to the intricate cooling passages desired inside the turbine blade. A precision die or mold is also created which defines the precise 3-D external surface of the turbine blade including its airfoil, platform, and integral dovetail. A schematic view of such a mold structure is shown in FIG. 2. The ceramic core 200 is assembled inside two die halves which form a space or void therebetween that defines the resulting metal portions of the blade. Wax is injected into the assembled dies to fill the void and surround the ceramic core encapsulated therein. The two die halves are split apart and removed from the molded wax. The molded wax has the precise configuration of the desired blade and is then coated with a ceramic material to form a surrounding ceramic shell 202. Then, the wax is melted and removed from the shell 202 leaving a corresponding void or space 201 between the ceramic shell 202 and the internal ceramic core 200 and tip plenum 204. Molten superalloy metal is then poured into the shell to fill the void therein and again encapsulate the ceramic core 200 and tip plenum 204 contained in the shell 202. The molten metal is cooled and solidifies, and then the external shell 202 and internal core 200 and tip plenum 204 are suitably removed leaving behind the desired metallic turbine blade in which the internal cooling passages are found. In order to provide a pathway for removing ceramic core material via a leaching process, a ball chute 203 and tip pins 205 are provided, which upon leaching form a ball chute and tip holes within the turbine blade that must subsequently brazed shut.

The cast turbine blade may then undergo additional post-casting modifications, such as but not limited to drilling of suitable rows of film cooling holes through the sidewalls of the airfoil as desired for providing outlets for the internally channeled cooling air which then forms a protective cooling air film or blanket over the external surface of the airfoil during operation in the gas turbine engine. After the turbine blade is removed from the ceramic mold, the ball chute 203 of the ceramic core 200 forms a passageway that is later brazed shut to provide the desired pathway of air through the internal voids of the cast turbine blade. However, these post-casting modifications are limited and given the ever increasing complexity of turbine engines and the recognized efficiencies of certain cooling circuits inside turbine blades, more complicated and intricate internal geometries are required. While investment casting is capable of manufacturing these parts, positional precision and intricate internal geometries become more complex to manufacture using these conventional manufacturing processes. Accordingly, it is desired to provide an improved casting method for three dimensional components having intricate internal voids.

U.S. Patent No. 9,039,382, entitled "Blade Skirt" describes a turbine blade include details of the blade root. The blade 300 typically has an airfoil 302, a platform 304, a shank 306, and a multi-lobe dovetail 308 having a fir tree configuration. On the forward side of the blade 300, there is a forward angel wing 310. On the aft side of the blade 300, there is a distal aft angel wing 312 radially inward of that is a proximal aft angel wing 314 with a gap therebetween. Proximal of the aft proximal angel wing 314, there is a fillet 316 that blends into a blade skirt 318. A recess may be provided within the shank portion 306 between the forward and aft sides of the blade 300. Within that recess, there is a forward damper retention lug 324 and an aft damper retention lug 326, which are used in conjunction with one another to retain a damper (not shown). The dovetail section 308 is inserted in a rotor (not shown) such that the dovetail lobes 328 mate with the rotor to radially fix the blade in place.

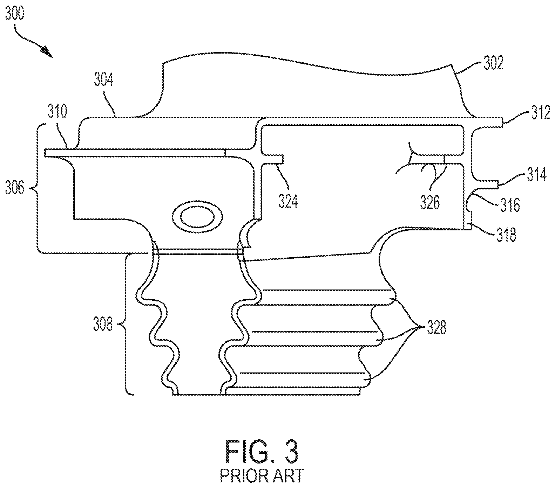

During the investment casting process, the entire structure shown in FIG. 3 is prepared in wax form, and then the ceramic shell is formed over the wax. Unless projecting features (i.e., angel wing, blade skirt, damper lugs) in the root portion of the turbine blade are made sufficiently thick, these features will deform upon removal from the wax mold, during handling of the wax, during handling of the final metal part, or while forming the ceramic shell. For example, the minimum dimension of angel wings, skirts and damper lugs must be greater than 25 mils (0.64 mm), preferably greater than 30 mils (0.8 mm).

There remains a need to prepare ceramic core-shell molds produced using higher resolution methods that are capable of providing fine detail cast features in the end-product of the casting process.

US 6 117612 discloses photocurable ceramic resins having solids loadings in excess of 40 volume percent and a viscosity of less than 3000 mPaxs are suitable for multi-layer fabrication of green ceramic parts by stereolithography and similar techniques.

US 2008/006384 A1 discloses an investment casting pattern component has a spine and a number of tines extending from the spine.

US 8 851 151 discloses a system for producing cast components from molten metal.

### SUMMARY

The invention is defined by the appended claims. In one aspect, the invention relates to a method of making a ceramic casting mold in accordance with claim 1.

In another aspect, the invention relates to a method of preparing a turbine blade or vane in accordance with claim 2.

Preferably the single crystal metal is a superalloy.

In one aspect the turbine blade or vane root component has a minimum dimension in the range of 0.1 and 0.6 mm. In another aspect the turbine blade or vane root component has a minimum dimension in the range of 0.2 and 0.5 mm.

In one aspect the turbine blade or vane root component is an angel wing, skirt or damper lug.

### BRIEF DESCRIPTION OF THE DRAWINGS

FIG. 1 is a flow diagram showing the steps for conventional investment casting.
FIG. 2 is a schematic diagram showing an example of a conventional scheme for a core-shell mold with ball chute prepared by a conventional process.
FIG. 3 shows a perspective view of a prior art integrated core-shell mold with ties connecting the core and shell portions.
FIGS. 4, 5, 6 and 7 show schematic lateral sectional views of a device for carrying out successive phases of the method sequence for direct light processing (DLP).
FIG. 8 shows a schematic sectional view along the line A-A of FIG. 7.
FIG. 9 shows a perspective view of a turbine blade root portion made in accordance with an embodiment of the present invention

### DETAILED DESCRIPTION

The detailed description set forth below in connection with the appended drawings is intended as a description of various configurations and is not intended to represent the only configurations in which the concepts described herein may be practiced. The detailed description includes specific details for the purpose of providing a thorough understanding of various concepts. However, it will be apparent to those skilled in the art that these concepts may be practiced without these specific details. For example, the present invention provides a preferred method for making cast metal parts, and preferably those cast metal parts used in the manufacture of jet aircraft engines. Specifically, the production of single crystal, nickel-based superalloy cast parts such as turbine blades, stator vanes, and shroud components can be advantageously produced in accordance with this invention. However, other cast metal components may be prepared using the techniques and integrated ceramic molds of the present invention.

The present inventors recognized that prior processes known for making turbine blades and stator vanes i.e. investment casting, lacked the fine resolution capability necessary to produce turbine blades and vanes having thin blade root elements. In particular, the wax processing step in investment casting severely limits the ability to manufacture turbine blades where the blade or vane root elements may be made as thin or as fine as desired.

In the present invention, the integrated core-shell is manufactured using direct light processing (DLP). DLP differs from powder bed and SLA processes in that the light curing of the polymer occurs through a window at the bottom of a resin tank that projects light upon a build platform that is raised as the process is conducted. With DLP an entire layer of cured polymer is produced simultaneously, and the need to scan a pattern using a laser is eliminated. Further, the polymerization occurs between the underlying window and the last cured layer of the object being built. The underlying window provides support allowing thin filaments of material to be produced without the need for a separate support structure. In other words, producing a thin filament of material bridging two portions of the build object is difficult and was typically avoided in the prior art. For example, U.S. Patent No. 8,851,151 assigned to Rolls-Royce Corporation describes a 3-D printing method of producing a ceramic core-shell mold that used vertical plate structures connected with short cylinders, the length of which was on the order of their diameter. Staggered vertical cavities are necessitated by the fact that the powder bed and SLA techniques disclosed in the ' 151 patent require vertically supported ceramic structures and the techniques are incapable of reliably producing thin indentations or recesses that correspond to thin turbine blade root components (i.e. angel wings, damper lugs, skirts) of the cast turbine blade. In addition, the available resolution within a powder bed is on the order of 1/8" (3.2 mm) making the production of thin turbine blade root components impracticable. For example, these thin turbine blade root components generally have a minimum dimension of less 0.64 mm, preferably in the range of 0.1 to 0.6 mm, more preferably in the range of 0.2 to 0.5 mm. As used herein, the term "minimum dimension" means "smallest possible dimension". Production of a turbine blade root component of such dimensions requires a resolution simply not available in a powder bed process. Similarly, stereolithography is limited in its ability to produce such thin indentations due lack of support and resolution problems associated with laser scattering. But the fact that DLP exposes the entire length of the indentation and supports it between the window and the build plate enables producing sufficiently thin indentations having the desired minimum dimensions. Although powder bed and SLA may be used to produce indentations, their ability to produce sufficiently fine indentations as discussed above is limited.

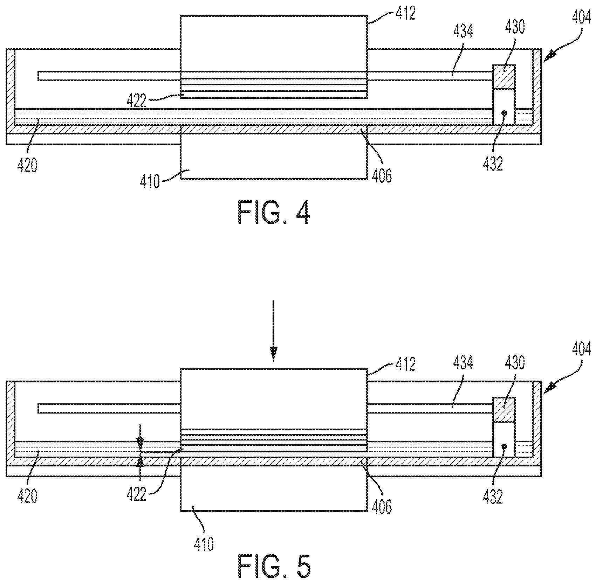

One suitable DLP process is disclosed in U.S. Patent No. 9,079,357 assigned to Ivoclar Vivadent AG and Technische Universitat Wien, as well as WO 2010/045950 A1 and US 2011310370, which are discussed below
with reference to FIGS. 4-8. The apparatus includes a tank 404 having at least one translucent bottom portion 406 covering at least a portion of the exposure unit 410. The exposure unit 410 comprises a light source and modulator with which the intensity can be adjusted position-selectively under the control of a control unit, in order to produce an exposure field on the tank bottom 406 with the geometry desired for the layer currently to be formed. As an alternative, a laser may be used in the exposure unit, the light beam of which successively scans the exposure field with the desired intensity pattern by means of a mobile mirror, which is controlled by a control unit.

Opposite the exposure unit 410, a production platform 412 is provided above the tank 404; it is supported by a lifting mechanism (not shown) so that it is held in a height-adjustable way over the tank bottom 406 in the region above the exposure unit 410. The production platform 412 may likewise be transparent or translucent in order that light can be shone in by a further exposure unit above the production platform in such a way that, at least when forming the first layer on the lower side of the production platform 412, it can also be exposed from above so that the layer cured first on the production platform adheres thereto with even greater reliability.

The tank 404 contains a filling of highly viscous photopolymerizable material 420. The material level of the filling is much higher than the thickness of the layers which are intended to be defined for position-selective exposure. In order to define a layer of photopolymerizable material, the following procedure is adopted. The production platform 412 is lowered by the lifting mechanism in a controlled way so that (before the first exposure step) its lower side is immersed in the filling of photopolymerizable material 420 and approaches the tank bottom 406 to such an extent that precisely the desired layer thickness (see FIG. 5) remains between the lower side of the production platform 412 and the tank bottom 406. During this immersion process, photopolymerizable material is displaced from the gap between the lower side of the production platform 412 and the tank bottom 406. After the layer thickness has been set, the desired position-selective layer exposure is carried out for this layer, in order to cure it in the desired shape. Particularly when forming the first layer, exposure from above may also take place through the transparent or translucent production platform 412, so that reliable and complete curing takes place particularly in the contact region between the lower side of the production platform 412 and the photopolymerizable material, and therefore good adhesion of the first layer to the production platform 412 is ensured. After the layer has been formed, the production platform is raised again by means of the lifting mechanism.

These steps are subsequently repeated several times, the distance from the lower side of the layer 422 formed last to the tank bottom 406 respectively being set to the desired layer thickness Δ and the next layer thereupon being cured position-selectively in the desired way.

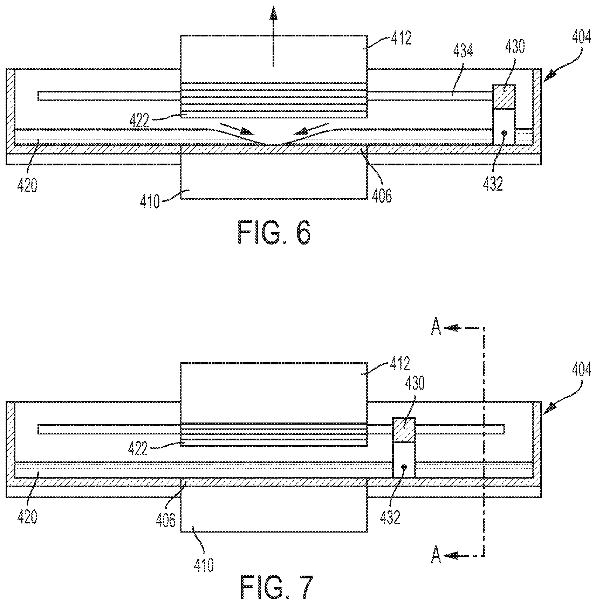

After the production platform 412 has been raised following an exposure step, there is a material deficit in the exposed region as indicated in FIG. 6. This is because after curing the layer set with the thickness Δ, the material of this layer is cured and raised with the production platform and the part of the shaped body already formed thereon. The photopolymerizable material therefore missing between the lower side of the already formed shaped body part and the tank bottom 406 must be filled from the filling of photopolymerizable material 420 from the region surrounding the exposed region. Owing to the high viscosity of the material, however, it does not flow by itself back into the exposed region between the lower side of the shaped body part and the tank bottom, so that material depressions or "holes" can remain here.

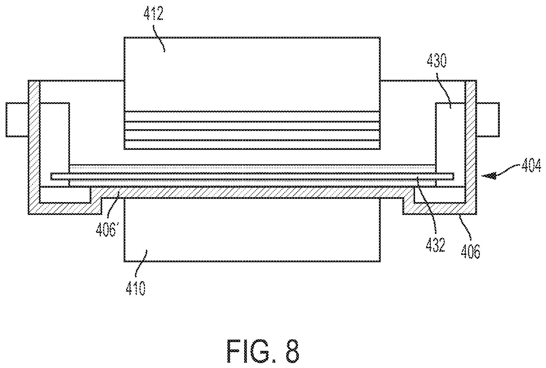

In order to replenish the exposure region with photopolymerizable material, an elongate mixing element 432 is moved through the filling of photopolymerizable material 420 in the tank. In the exemplary embodiment represented in FIGS. 4 to 8, the mixing element 432 comprises an elongate wire which is tensioned between two support arms 430 mounted movably on the side walls of the tank 404. The support arms 430 may be mounted movably in guide slots 434 in the side walls of the tank 404, so that the wire 432 tensioned between the support arms 430 can be moved relative to the tank 404, parallel to the tank bottom 406, by moving the support arms 430 in the guide slots 434. The elongate mixing element 432 has dimensions, and its movement is guided relative to the tank bottom, such that the upper edge of the elongate mixing element 432 remains below the material level of the filling of photopolymerizable material 420 in the tank outside the exposed region. As can be seen in the sectional view of FIG. 8, the mixing element 432 is below the material level in the tank over the entire length of the wire, and only the support arms 430 protrude beyond the material level in the tank. The effect of arranging the elongate mixing element below the material level in the tank 404 is not that the elongate mixing element 432 substantially moves material in front of it during its movement relative to the tank through the exposed region, but rather this material flows over the mixing element 432 while executing a slight upward movement. The movement of the mixing element 432 from the position shown in FIG. 6, to, for example, a new position in the direction indicated by the arrow A, is shown in FIG. 7. It has been found that by this type of action on the photopolymerizable material in the tank, the material is effectively stimulated to flow back into the material-depleted exposed region between the production platform 412 and the exposure unit 410.

The movement of the elongate mixing element 432 relative to the tank may firstly, with a stationary tank 404, be carried out by a linear drive which moves the support arms 430 along the guide slots 434 in order to achieve the desired movement of the elongate mixing element 432 through the exposed region between the production platform 412 and the exposure unit 410. As shown in FIG. 8, the tank bottom 406 has recesses 406' on both sides. The support arms 430 project with their lower ends into these recesses 406'. This makes it possible for the elongate mixing element 432 to be held at the height of the tank bottom 406, without interfering with the movement of the lower ends of the support arms 430 through the tank bottom 406.

Other alternative methods of DLP may be used to prepare the integrated core-shell molds of the present invention. For example, the tank may be positioned on a rotatable platform. When the workpiece is withdrawn from the viscous polymer between successive build steps, the tank may be rotated relative to the platform and light source to provide a fresh layer of viscous polymer in which to dip the build platform for building the successive layers.

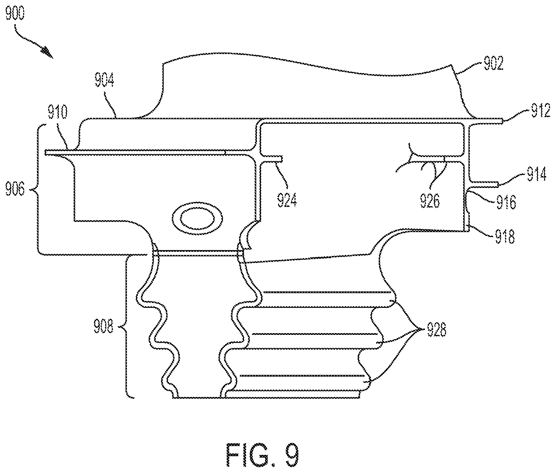

The present invention may be used to make turbine blades and stator vanes having root feature minimum dimensions of less than 0.64 mm. As shown in FIG. 9, the blade 900 includes an airfoil 902, a platform 904, a shank 906, and a multi-lobe dovetail 908 having a fir tree configuration. The angel wings 910, 912 and 914, skirt 918, and damper retention lugs 924, 926 preferably have a thickness of less than 0.64 mm. In general angel wings may range in thickness from 0.1 to 0.6 mm, more preferably in the range of 0.2 and 0.5 mm. The thinner dimensions of the turbine blade or vane root features allows for a significant reduction in weight and enables novel designs. It will be appreciated that the specific design of the blade shown in FIG. 9 is for illustrative purposes only and in no way limits the invention. It should be noted that turbine blades and vanes generally have root features and that those turbine blade or vane designs may be prepared using the present methods in order to achieve a reduction in weight.

After printing the core-shell mold structures in accordance with the invention, the core-shell mold may be cured and/or fired depending upon the requirements of the ceramic core photopolymer material. Molten metal may be poured into the mold to form a cast object in the shape and having the features provided by the integrated core-shell mold. In the case of a turbine blade or stator vane, the molten metal is preferably a superalloy metal that formed into a single crystal superalloy turbine blade or stator vane using techniques known to be used with conventional investment casting molds.

This written description uses examples to disclose the invention, including the preferred embodiments, and also to enable any person skilled in the art to practice the invention, including making and using any devices or systems and performing any incorporated methods. The patentable scope of the invention is defined by the claims.

## Claims

1. A method for fabricating an integrated ceramic core-shell casting mold for a turbine blade or vane using direct
light processing (DLP), comprising:
(a) contacting a cured portion of a workpiece with a liquid ceramic photopolymer;
(b) irradiating a portion of the liquid ceramic photopolymer adjacent to the cured portion through a window contacting the liquid ceramic photopolymer;
(c) removing the workpiece from the uncured liquid ceramic photopolymer; and
(d) repeating steps (a) - (c) until a ceramic casting mold is formed, the ceramic casting mold comprising:
(1) a core portion and a shell portion with at least one cavity between the core portion and the shell portion, the cavity adapted to define the shape of the turbine blade or vane upon casting and removal of the ceramic casting mold, and the core-shell casting mold includes integrated ceramic indentations between the core and shell of the mold which is utilized to form thin root components in the turbine blade or stator vane made from this mold, and
(2) the cavity defining a turbine blade or vane root component having a minimum dimension of less than 0.64 mm.

2. A method of preparing a single crystal turbine blade or vane comprising:
(a) pouring a liquid metal into an integrated ceramic core-shell casting mold fabricated by the method according
to claim 1 and solidifying the liquid metal to form the turbine blade or vane, the ceramic casting mold comprising:
(1) a core portion and a shell portion with at least one cavity between the core portion and the shell portion, the cavity adapted to define the shape of the turbine blade or vane upon casting and removal of the ceramic casting mold, and
(2) the cavity defining a turbine blade or vane root component having a minimum dimension of less than 0.64 mm.
(b) removing the ceramic casting mold from the cast component by leaching at least a portion of the ceramic core through the holes in the turbine blade or vane.

3. The method of claim 2, wherein the turbine blade or vane root component has a minimum dimension in the range of 0.1 and 0.6 mm.

4. The method of any one of claims 2 and 3, wherein the turbine blade or vane root component is an angel wing, skirt, or damper lug.

## Patentansprüche

1. Verfahren zum Herstellen einer integrierten keramischen Kern-Mantel-Gussform für eine für eine Turbinenschaufel oder -leitschaufel unter Verwendung direkter Lichtverarbeitung (DLP), umfassend:
(a) Inkontaktbringen eines gehärteten Teils eines Werkstücks mit einem flüssigen keramischen Photopolymer;
(b) Bestrahlen eines Teils des flüssigen keramischen Photopolymers, der an den gehärteten Teil angrenzt, durch ein Fenster, das mit dem flüssigen keramischen Photopolymer in Kontakt steht;
(c) Entfernen des Werkstücks aus dem ungehärteten flüssigen keramischen Photopolymer; und
(d) Wiederholen der Schritte (a) - (c), bis eine keramische Gussform gebildet ist, wobei die keramische Gussform umfasst:
(1) einen Kernbereich und einen Mantelbereich mit mindestens einem Hohlraum zwischen dem Kernbereich und dem Mantelbereich, wobei der Hohlraum geeignet ist, die Form der Turbinenschaufel oder -leitschaufel beim Gießen und Entfernen der keramischen Gussform zu definieren, und die Kern-Mantel-Gussform integrierte keramische Vertiefungen zwischen dem Kern und dem Mantel der Form aufweist, die verwendet werden, um dünne Grundkomponenten in der aus dieser Form hergestellten Turbinenschaufel oder -leitschaufel zu bilden, und
(2) der Hohlraum eine Grundkomponente der Turbinenschaufel oder -leitschaufel mit einer Mindestabmessung von weniger als 0,64 mm definiert.

2. Verfahren zur Herstellung einer einkristallinen Turbinenschaufel oder -leitschaufel, umfassend:
(a) Gießen eines flüssigen Metalls in eine integrierte keramische Kern-Mantel-Gussform, die nach dem Verfahren gemäß Anspruch 1 hergestellt wurde, und Verfestigen des flüssigen Metalls, um die Turbinenschaufel oder -leitschaufel zu bilden, wobei die keramische Gussform umfasst:
(1) einen Kernbereich und einen Mantelbereich mit mindestens einem Hohlraum zwischen dem Kernbereich und dem Mantelbereich, wobei der Hohlraum geeignet ist, die Form der Turbinenschaufel oder -leitschaufel beim Gießen und Entfernen der keramischen Gussform zu definieren, und
(2) der Hohlraum eine Grundkomponente der Turbinenschaufel oder -leitschaufel mit einer Mindestabmessung von weniger als 0,64 mm definiert.
(b) Entfernen der keramischen Gussform von der gegossenen Komponente durch Auslaugen mindestens eines Teils des keramischen Kerns durch die Löcher in der Turbinenschaufel oder -leitschaufel.

3. Verfahren nach Anspruch 2, worin die Grundkomponente der Turbinenschaufel oder - leitschaufel eine Mindestabmessung im Bereich von 0,1 bis 0,6 mm aufweist.

4. Verfahren nach einem der Ansprüche 2 und 3, worin die Turbinenschaufel oder - leitschaufel-Grundkomponente ein Engelsflügel, eine Schürze oder eine Dämpfungsnase ist.

## Revendications

1. Procédé de fabrication d'un moule de coulée cœur-coque céramique intégrée pour une pale de turbine ou une aube, utilisant un traitement d'irradiation directe (DLP), comprenant de :
(a) mettre en contact une portion solidifiée d'une pièce de travail avec un photopolymère liquide céramique ;
(b) irradier une portion du photopolymère liquide céramique adjacente à la portion solidifiée à travers une fenêtre en contact avec le photopolymère liquide céramique ;
(c) enlever la pièce de travail du photopolymère liquide céramique non polymérisé ; et
(d) répéter les étapes (a) - (c) jusqu'à ce qu'un moule de coulée céramique soit formé, le moule de coulée céramique comprenant :
(1) une portion cœur et une portion coque avec au moins une cavité entre la portion cœur et la portion coque, la cavité étant adaptée pour définir la forme de la pale de turbine ou de l'aube à la coulée et à l'extraction du moule de coulée céramique, et le moule de coulée cœur-coque incluant des indentations céramiques intégrées entre le cœur et la coque du moule qui est utilisé pour former des composants racines minces dans la pale de turbine ou l'aube de stator fabriquée à partir de ce moule, et
(2) la cavité définissant un composant racine de la pale de turbine ou de l'aube ayant une dimension minimale inférieure à 0,64 mm.

2. Procédé de préparation d'une pale de turbine ou aube monocristalline comprenant de :
(a) verser un métal liquide dans un moule de coulée cœur-coque céramique intégré fabriqué par le procédé selon la revendication 1 et solidifier le métal liquide pour former la pale de turbine ou aube, le moule de coulée céramique comprenant :
(1) une portion cœur et une portion coque avec au moins une cavité entre la portion cœur et la portion coque, la cavité étant adaptée pour définir la forme de la pale de turbine ou de l'aube à la coulée et à l'extraction du moule de coulée céramique, et
(2) la cavité définissant un composant racine de la pale de turbine ou de l'aube ayant une dimension minimale inférieure à 0,64 mm.
(b) enlever le moule de coulée céramique du composant coulé en faisant couler au moins une partie du cœur céramique à travers les orifices dans la pale de turbine ou l'aube.

3. Procédé selon la revendication 2, dans lequel le composant racine de la pale de turbine ou de l'aube a une dimension minimale dans la gamme entre 0,1 et 0,6 mm.

4. Procédé selon l'une quelconque des revendications 2 et 3, dans lequel le composant racine de la pale de turbine ou de l'aube est une aile d'ange, une jupe ou une oreille d'amortisseur.
